# EUROPÄISCHE PATENTSCHRIFT

(11) **EP 1 784 738 B1**
(45) Veröffentlichungstag und Bekanntmachung des Hinweises auf die Patenterteilung: **21.01.2009**
(21) Anmeldenummer: 06761760.5
(22) Anmeldetag: 04.07.2006
(51) Int. Cl.: G06F 13/40

(54) **STECKERPLATINE ZUM EINSATZ IN EINEM EINSCHUBRAHMEN FÜR PERIPHERIEGERÄTE**
BACKPLANE FOR USE IN A RACK FOR PERIPHERAL DEVICES
PLAQUE ENFICHABLE DESTINEE A ETRE UTILISEE DANS DES RACKS POUR APPAREILS PERIPHERIQUES

(30) Priorität: 14.07.2005 DE 102005033004
(43) Veröffentlichungstag der Anmeldung: 16.05.2007
(73) Patentinhaber: Fujitsu Siemens Computers GmbH, 80807 München (DE)
(72) Erfinder: NEHLING, Kornelius, 33605 Bielefeld (DE); DEPTA, Robert, 86179 Augsburg (DE)
(74) Vertreter: Epping - Hermann - Fischer
(86) Internationale Anmeldenummer: PCT/DE2006/001158
(87) Internationale Veröffentlichungsnummer: WO 2007/006267

(56) Entgegenhaltungen:
- US-A1- 2003 227 728
- KEVIN GRAY: "Serial Attached SCSI: A Serial Interface for Enterprise Storage Systems" 31. Juli 2003 (2003-07-31), MAXTOR CORPORATION , XP002407997 Gefunden im Internet: URL:http://www.maxtor.com/_files/maxtor/en _us/documentation/white_papers_application /serial_interface_for_enterprise.pdf> Seite 2

## Beschreibung

Die Erfindung betrifft eine Steckerplatine zum Einsatz in einem Einschubrahmen für Peripheriegeräte. Die Steckerplatine umfasst mindestens einen Steckplatz mit Steckverbinder zum Anschluss von in den Einschubrahmen eingeschobenen Peripheriegeräten, mindestens einen weiteren Steckverbinder zur Verbindung der Steckerplatine mit mindestens einer Steuervorrichtung, wobei der weitere Steckverbinder zum Austausch von Signalen zwischen der Steuervorrichtung und den Peripheriegeräten durch die Steckerplatine mit einem oder mehreren der Steckverbinder der Steckplätze verbunden ist, und jeweils eine, einem Steckplatz zugeordnete optische Signaleinrichtung. Weiterhin betrifft die Erfindung einen Computer mit einem Einschubrahmen zur Aufnahme mehrerer Peripheriegeräte.

Derartige System werden häufig bei modular aufgebauten Signal-, Datenverarbeitungs- oder Kommunikationseinrichtung eingesetzt. In den Einschubrahmen können Peripheriegeräte, Steckkarten oder sonstige Funktionsmodule, die mit Steckkontakten versehen sind, eingesetzt werden. Quer zur Einschubrichtung verläuft am hinteren Ende der Einschubfächer des Einschubrahmens die Steckerplatine, auch "backplane" genannt, bei der für jedes Einschubfach Steckplätze mit Steckverbindern vorgesehen sind, mit denen die Steckkontakte der eingeschobenen Peripheriegeräte zusammen wirken. Auf der Steckerplatine steht ein weiterer Steckverbinder zum Anschluss an die Steuervorrichtung für die eingeschobenen Peripheriegeräte zur Verfügung. Durch die Steckerplatine sind die Steckverbinder für die eingeschobenen Geräte mit den weiteren Steckverbindern für die Steuervorrichtung verbunden, was entweder über eine busartige, parallele Verbindung oder auch über eine direkte Verbindung (Punkt-zu-Punkt-Verbindung) erfolgen kann. Es sind auch gemischte Strukturen denkbar, bei denen z.B. Stromversorgungsleitungen zwischen den einzelnen Steckverbindern busartig parallel, Datenleitung jedoch direkt ausgeführt sind.

Im Datenverarbeitungsbereich werden solche Steckerplatinen häufig eingesetzt, wenn ein oder mehrere gleichartige Peripheriegeräte, beispielsweise Festplattenlaufwerke, in einem Gehäuse vorgesehen sind. Insbesondere Netzwerkdienstanbieter setzen häufig Servercomputer mit einer Vielzahl von Festplattenlaufwerken in Form eines RAID-Systems (Redundant Array of Independent Devices) ein. Bei Ausfall eines Festplattenlaufwerks bietet die Anordnung der Laufwerke in einem Einschubrahmen die Möglichkeit, das fehlerhafte Laufwerk schnell und einfach tauschen zu können.

Ein Problem kann dabei mangelnde, oder schlimmer, nur scheinbar gegebene Kompatibilität zwischen den zu tauschenden Geräten darstellen. SAS (Serial Attached Small Computer System Interface) und SATA (Serial Advanced Technology Attachment) sind beispielsweise zwei Spezifikationen für einen Hochgeschwindigkeitsdatenbus mit serieller Datenübertragung. Systeme und Geräte, die nach einer dieser Spezifikationen betrieben werden (im Folgenden ist dieses durch Voranstellen der entsprechenden Abkürzung angegeben), werden im Serverbereich häufig nebeneinander in gemischten Umgebungen betrieben. Dabei sind für SAS- und SATA-Systeme zunächst einmal teilweise identische Steckverbinder vorgesehen. Die signaltechnischen Spezifikationen beider Systeme sind in ihren Grundzügen ähnlich, unterscheiden sich jedoch in Details, z.B. den Signalamplituden. Das eingesetzte Datenformat ist ebenfalls unterschiedlich.

SAS-Steuervorrichtungen verfügen dabei meist über die zusätzliche Fähigkeit, Signale und Datenformate nach der SATA-Spezifikation verarbeiten zu können. Solche SAS/SATA-Steuervorrichtungen können somit sowohl mit SAS-Peripheriegeräten als auch mit SATA-Peripheriegeräten zusammenarbeiten, wohingegen SATA-Steuervorrichtungen nur mit SATA-Peripheriegeräten zusammenarbeiten können. Die Kombination von einer SATA-Steuervorrichtung mit einem SAS-Peripheriegerät arbeitet dagegen nicht oder nicht zuverlässig.

Um solche elektrisch nicht kompatiblen Kombinationen zu vermeiden, sieht die SATA-Spezifikation eine Nase am Peripheriegerätesteckverbinder sowie eine korrespondierende Lücke am entsprechenden Gegenpart, also z.B. beim Steckverbinder eines Steckplatzes auf einer Steckerplatine vor. Damit lassen sich SAS- und SATA-Peripheriegeräte an SAS-Steckerplatinen einsetzen, aber nur SATA-Peripheriegeräte an SATA-Steckplätzen. Durch diese mechanischen Sicherung kann eine nicht kompatible Kombination von Peripheriegeräten und Steuervorrichtungen zwar prinzipiell verhindert werden, sie ist allerdings mit einigen Nachteilen verbunden.

Zum einen ist die Gefahr der Zerstörung von Steckverbindern und damit auch den Peripheriegeräten gegeben, wenn die mechanische Sperre durch eine zu große Kraftaufwendung überwunden wird, was in der Praxis "wenn es schnell gehen soll" durchaus vorkommen kann. Zum anderen müssen Hersteller von Steckerplatinen diese in beiden Versionen anbieten. Darüber hinaus muss beim Betreiben von Systemen darauf geachtet werden, dass die jeweils eingesetzte Version der Steckerplatine mit der benutzten Steuervorrichtung korrespondiert. Wird beispielsweise die Steuervorrichtung von SATA auf SAS/SATA getauscht, muss auch die Steckerplatine getauscht werden, wenn ein SAS fähiges Peripheriegerät genutzt werden soll. Werden dagegen prinzipiell SAS-Steckerplatinen eingesetzt, um dieses Problem zu umgehen, ist wiederum kein Schutz vor der inkompatiblen Kombination eines SAS-Peripheriegeräts an einer SATA-Steuervorrichtung gegeben.

Insbesondere bei großen Systemen mit vielen verschiedenen Servern und Peripheriegeräten, z.B. bei den sogenannten Serverfarmen, bei denen oft nebeneinander unterschiedlichste Hardwarekonfigurationen vorliegen, die sich durch den Austausch von Komponenten nach einem Systemausfall auch oft ändern können, ist die mechanische Lösung nicht geeignet um vor versehentlich installierten nicht kompatiblen Kombinationen zu schützen.

Aus der Druckschrift US 2003/0227728 A1 ist eine Überwachungsschaltung zum Schutz einer in ein Computerhauptplatine eingesteckten Videokarte bekannt. Dabei wird von der Überwachungsschaltung eine von der Videokarte bereitgestellte Information betreffend die Höhe der benötigten Versorgungsspannung der Videokarte abgefragt und ein Warnsignal ausgegeben, wenn die Computerhauptplatine nicht in der Lage ist, eine Versorgungsspannung dieser Höhe zu liefern.

Es ist daher eine Aufgabe der vorliegenden Erfindung, eine Steckerplatine anzugeben, die flexibel mit Steuervorrichtungen und Peripheriegeräten, die nach verschiedenen Spezifikationen arbeiten, nutzbar ist und gleichzeitig vor dem Einsatz von inkompatiblen Kombinationen von Steuervorrichtung und Peripheriegerät schützt. Es ist weiterhin eine Aufgabe der vorliegenden Erfindung, eine Datenverarbeitungsvorrichtung vorzustellen, bei dem Peripheriegeräte, die nach verschiedenen Spezifikationen arbeiten, in einem Einschubrahmen flexibel und ohne die Gefahr von Inkompatibilitäten eingesetzt werden können.

Diese Aufgabe wird gelöst durch eine Steckerplatine gemäß Patentanspruch 1 sowie eine Datenverarbeitungsvorrichtung gemäß Patentanspruch 12.

Die erfindungsgemäße Steckerplatine zeichnet sich durch eine Überwachungseinrichtung aus, die dazu eingerichtet ist, für jedes angeschlossene Peripheriegerät zu ermitteln, ob dieses Peripheriegerät mit der mit ihm verbundenen Steuervorrichtung elektrisch kompatibel ist, und falls ermittelt wird, das eines der Peripheriegeräte mit der mit ihm verbundenen Steuervorrichtung nicht kompatibel ist, die dem Steckplatz dieses Peripheriegerätes zugeordnete optische Signaleinrichtung zu aktivieren.

Die Erkennung einer Inkompatibilität durch die Überwachungseinrichtung erlaubt die Verwendung von Steckverbindern zu den Peripheriegeräten, die mechanisch mit mindestens zwei verschiedenen Typen von Peripheriegeräten nach verschiedenen Spezifikation zusammenwirken können und die Verwendung von weiteren Steckverbindern zu den Steuervorrichtungen, die mechanisch mit mindestens zwei verschiedenen Typen von Steuervorrichtungen zusammenwirken können. Die mechanisch bewusst vertauschbar ausgeführten Steckverbinder erlauben einen flexiblen Einsatz der Steckerplatine. Durch die Überwachungseinrichtung wird der Benutzer dennoch vor nicht kompatiblen Kombinationen gewarnt und so die Gefahr von nicht erkannten inkompatiblen Konfigurationen gemindert.

Vorteilhafte Ausgestaltung und Weiterbildung der Erfindung sind in den abhängigen Ansprüchen angegeben.

Im Folgenden wird die Erfindung anhand von zwei Ausführungsbeispielen, dargestellt in zwei Figuren, näher erläutert.

Es zeigt
Figur 1 eine schematische Darstellung eines Datenverarbeitungssystems mit einem ersten Ausführungsbeispiel einer erfindungsgemäßen Steckerplatine und
Figur 2 eine schematische Darstellung eines Datenverarbeitungssystems mit einem zweiten Ausführungsbeispiel einer erfindungsgemäßen Steckerplatine.

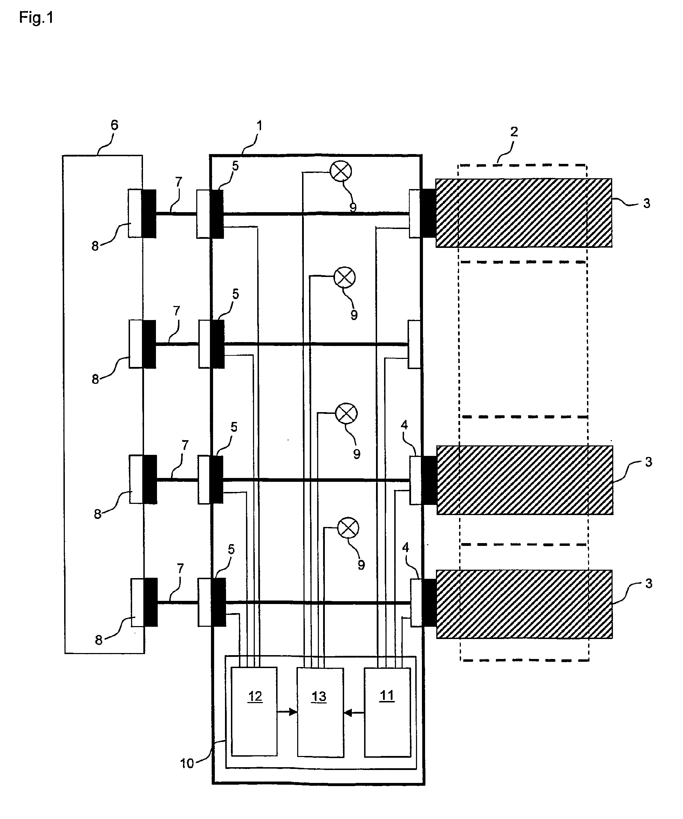

Figur 1 zeigt eine Steckerplatine 1, die zusammen mit einem Einschubrahmen 2 zur Aufnahme von Peripheriegeräten 3 Teil einer Datenverarbeitungsvorrichtung ist. Die Steckerplatine 1 weist Steckverbinder 4 zur Kontaktierung der eingeschobenen Peripheriegeräte 3 sowie weitere Steckverbinder 5 auf. Über die weiteren Steckverbinder 5 kann die Steckerplatine 1 mit einer Steuervorrichtung 6 über entsprechende Kabel 7 an Steckverbinder 8 der Steuervorrichtung 9 angeschlossen werden. Weiterhin sind auf der Steckerplatine 1 optische Signalvorrichtungen 9 vorgesehen, die mit einer Überwachungseinrichtung 10 verbunden sind. Die Überwachungseinrichtung 10 umfasst erste Erkennungsmittel 11 sowie zweite Erkennungsmittel 12 die jeweils mit den Steckverbindern 4 bzw. den weiteren Steckverbindern 5 verbunden sind. Die Überwachungseinrichtung 10 umfasst weiterhin einen Vergleicher 13, der mit dem ersten und dem zweiten Erkennungsmittel 11 und 12 in Verbindung steht.

Das in Figur 1 dargestellte System ist typisch für den Einsatz in einer Datenverarbeitungsvorrichtung, bei der z.B. mehrere Festplattenlaufwerke als Peripheriegeräte 3 in einem Einschubrahmen 2 vorgesehen sind. Die Festplattenlaufwerke können bei Bedarf schnell und einfach ausgetauscht werden, um z.B. eine hohe Verfügbarkeit der Datenverarbeitungsvorrichtung zu erreichen. Eine solche Datenverarbeitungsvorrichtung könnte ein Computer, z.B. Server, aber auch ein Speicherschrank sein. Je nach Datenverarbeitungsvorrichtung sind weitere Komponenten vorgesehen, die aus Gründen der Übersichtlichkeit hier nicht gezeigt sind. Beim Computer wären das beispielsweise eine Hauptplatine mit Prozessor, mit der die Steuereinrichtung 6 zum Datenaustausch in Verbindung stehen würde. Bei einem Speicherschrank wären entsprechend Komponenten vorgesehen, über die die Steuervorrichtung 6 Daten mit einem Netzwerk austauschen könnte.

Die Steuerplatine 1 weist für jedes Einschubfach des Einschubrahmens 2 einen Steckplatz mit Steckverbinder 4 auf. Die Anordnung dieser Steckverbinder 4 ist an den Einschubrahmen 2 angepasst, sodass ein in ein Einschubfach eingeschobenes Peripheriegerät mit seinen Steckkontakten mit dem jeweiligen Steckverbinder 4 zusammen wirkt. Exemplarisch sind in der Figur 4 Einschubfächer gezeigt, die erfindungsgemäße Steuerplatine 1 kann jedoch für eine beliebige Anzahl an Einschubfächern ausgelegt sein. Zu jedem Steckverbinder 4 zum Anschluss eines Peripheriegerätes 3 ist ein weiterer Steckverbinder 5 zum Anschluss an die Steuervorrichtung 6 vorgesehen. Im Bespiel ist jeder Steckverbinder 4 mit einer direkten Verbindung mit dem korrespondierenden weiteren Steckverbinder 5 verbunden. Diese Auslegung ist ein Erfordernis der benutzten Spezifikation, nachdem die Peripheriegeräte 3 und die Steuervorrichtung 6 Daten austauschen. Prinzipiell sind für die Architektur der Verbindung von Steuervorrichtung 6 über die weiteren Steckverbinder 5 zu den Steckverbindern 4 jedoch beliebige andere Strukturen denkbar. Beispielsweise ist möglich, dass von einem weiteren Steckverbinder 5 sternförmig oder parallel mehrere Steckverbinder 4 bedient werden. Auch ist denkbar, dass zwar elektrisch eine Punkt-zu-Punkt Verbindung existiert, mehrere der Verbindungsleitungen von einem Steckverbinder 4 jedoch in einem Steckverbinder 5 mechanisch zusammengefasst sind (sogenannte Multiportstecker).

Jedem Steckplatz und damit jedem Steckverbinder 4 ist eine optische Signaleinrichtung 9 zugeordnet. In der schematischen Zeichnung der Figur 1 sind diese optischen Signaleinrichtungen der Übersichtlichkeit halber auf der Steckerplatine 1 eingezeichnet. In einer Implementierung des Ausführungsbeispiels sollten die optischen Signaleinrichtungen 9 für einen Bediener gut sichtbar sein und eindeutig einem Einschubfach zugeordnet sein. Dieses kann beispielsweise durch Lichtwellenleiter in Form von Plexiglasstäben, die in den Einschubrahmen 2 eingearbeitet sind erreicht werden. Alternativ ist möglich, die optische Signaleinwirkung 9, z.B. in Form einer Leuchtdiode (LED) direkt im Einschubrahmen 2 an der den Steckverbindern 4 gegenüberliegenden Seite vorzusehen und über entsprechende Kabel mit der Steckerplatine 1 zu verbinden.

Beispielhaft wird im Folgenden die Funktion der Steckerplatine 1 an einer Steckerplatine erklärt, die für den Einsatz mit einer Steuervorrichtung 6 und Peripheriegeräten 3, die entweder nach der SAS- oder nach der SATA-Spezifikation ausgelegt sein können. Zu diesem Zweck sind zunächst einmal die Steckverbinder 4 und die weiteren Steckverbinder 5 gemäß der SAS-Spezifikation ausgeführt, sodass sich mechanisch sowohl SASwie SATA-Peripheriegeräte 3 und Steuervorrichtungen 6 anschließen lassen. Wie bereits in der Einleitung ausgeführt, können Steuervorrichtungen 6, die gemäß der SAS-Spezifikation arbeiten, sowohl SAS- als auch SATA-Peripheriegeräte 3 bedienen. Von allen möglichen Kombinationen von Steuervorrichtung- und Peripheriegerättypen gilt es also, die nicht kompatible Konfiguration einer SATA-Steuervorrichtung 6 mit einem SAS-Peripheriegerät 3 zu detektieren und dem Benutzer zu signalisieren.

Zu diesem Zweck ist die Überwachungseinrichtung 10 vorgesehen, die das erste Erkennungsmittel 11 und das zweite Erkennungsmittel 12 sowie den Vergleicher 13 umfasst. Aufgabe des ersten Erkennungsmittel 11 ist die Erkennung der Typen der angeschlossenen Peripheriegeräte 3. Diese Typerkennung kann auf verschiedene Art und Weise geschehen.

Im gezeigten Ausführungsbeispiel werden ausgewählte Leitungen eines jeden Steckverbinders 4 abgefragt und durch das erste Erkennungsmittel 11 ausgewertet. Beispielsweise sieht die SAS-Spezifikation für Peripheriegeräte 3 vor, sämtliche Daten- und Masseleitungen doppelt auszuführen (Multiport), um aus Zuverlässigkeitsgründen beim Ausfall des ersten Leitungssatzes (Port) auf den zweiten umzuschalten. Die SATA-Spezifikation sieht diesen zweiten Leitungssatz nicht vor, weswegen laut Spezifikation die entsprechenden Anschlüsse des Steckverbinders 4 durch ein SATA-Peripheriegerät 3 nicht beschaltet sind. Dieser Unterschied zwischen einem SAS- und einem SATA-Peripheriegerät kann durch eine Impedanzmessung durch das erste Erkennungsmittel 11 leicht herausgefunden werden.

Eine weitere Möglichkeit wäre, die Signalpegel auf den Datenleitungen zu überwachen, die gemäß der Spezifikationen unterschiedliche Werte für SAS-und SATA-Peripheriegeräte 3 haben. Die Ergebnisse der Typerkennung übermittelt das erste Erkennungsmittel 11 dem Vergleicher 13.

Analog zum ersten Erkennungsmittel 11 ist das zweite Erkennungsmittel 12 dazu eingerichtet, den Typ der Steuervorrichtung 6 zu ermitteln, das mit dem jeweiligen Peripheriegerät 3 verbunden ist. Auch hier bietet sich wieder als Methode eine Überwachung der Signalamplituden oder der Beschaltung bestimmter Leitungen an. Alternativ kann auch eine mit den Daten übertragene Kennung der Steuervorrichtung 6 eingesetzt werden. Unabhängig von der Zahl der eingesetzten weiteren Steckverbinder 5 (von diesen könnten ja mehrere Steckverbinder 4 und damit Peripheriegeräte 3 bedient werden) und unabhängig von der tatsächlichen Zahl der angeschlossenen Steuervorrichtungen 6 ermittelt das zweite Erkennungsmittel 12 die Information über den Typ der Steuervorrichtung 6 für jeden Steckplatz und somit jedes Peripheriegerät 3 separat und übermittelt diese Information dem Vergleicher 13. Dem Vergleicher 13 steht somit ein Wertepaar an Typeninformation für jedes eingeschobene Peripheriegerät 3 zur Verfügung. Jedes Wertepaar an Typeninformation wird daraufhin auf nicht kompatible Kombinationen untersucht, im gezeigten Beispiel also auf die Kombination einer SATA-Steuervorrichtung mit einem SAS-Peripheriegerät. Nicht erlaubte Kombinationen sind dem Vergleicher 13 dabei vorgegeben, beispielsweise durch einprogrammierbare Tabellen oder durch Schalter oder Steckerbrücken oder ähnliche Kodierungsmaßnahmen.

Wird vom Vergleicher 13 eine nicht kompatible Typenkombination bei einem der Peripheriegeräte 3 festgestellt, aktiviert er die optische Signaleinrichtung 9, die dem Steckplatz zugeordnet ist, in dem sich das nicht mit seiner Steuervorrichtung 6 kompatible Peripheriegerät 3 befindet. Der Bediener, der dies Peripheriegerät 3 z.B. gerade eingeschoben hat, wird auf diese Weise auf die Inkompatibilität aufmerksam gemacht und kann Abhilfe schaffen.

Einbaurahmen nach dem Stand der Technik weisen häufig bereits für jedes Einschubfach eine optische Signaleinrichtung auf, die beispielsweise zur Anzeige der Aktivität eines eingeschobenen Peripheriegeräts genutzt wird. Die erfindungsgemäße optische Signaleinrichtung 9 kann mit dieser kombiniert werden, indem z.B. eine mehrfarbige Anzeige vorgesehen wird oder indem sich die erfindungsgemäße Warnmeldung, die auf Inkompatibilitäten hinweist, falls gewünscht von anderen optischen Signalen unterscheidet (z.B. durch Blinken oder durch Blinken in einer charakteristischen Frequenz oder einem charakteristischen zeitlichen Ablauf).

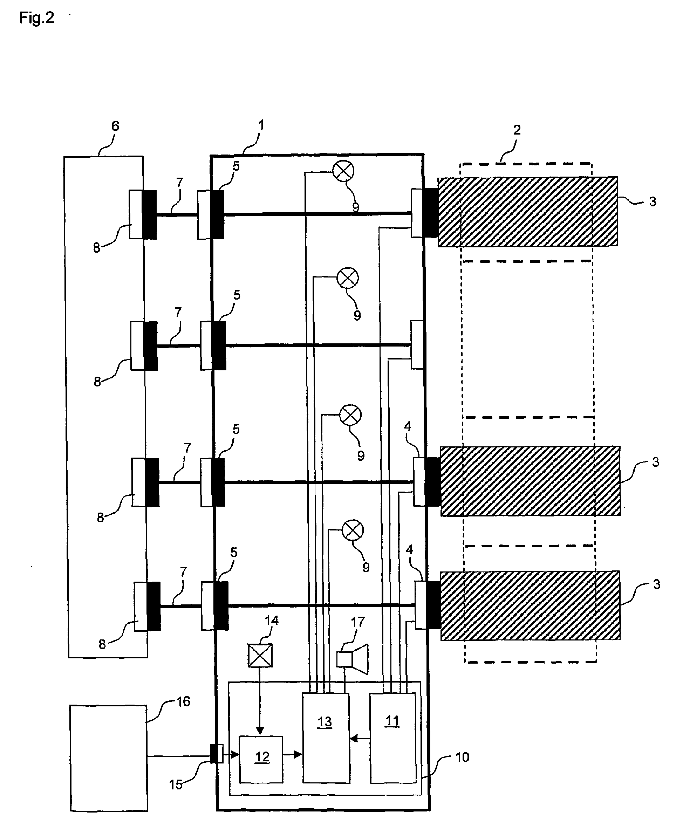

Das in Figur 2 gezeigte Ausführungsbeispiel unterscheidet sich von dem in Figur 1 dargestellten Beispiel vor allem in der Ausgestaltung des zweiten Erkennungsmittels 12.

In diesem Ausführungsbeispiel ist das zweite Erkennungsmittel 12 nicht dazu ausgelegt, den Typ der angeschlossenen Steuervorrichtung 6 anhand der elektrischen Signale der Steuervorrichtung 6 zu erkennen. Vielmehr sind Möglichkeiten vorgesehen, dem zweiten Erkennungsmittel 12 den Typ der Steuervorrichtung 6 als Konfigurationsinformationen mitzuteilen. Zu diesem Zweck ist eine Schnittstelle 14 vorgesehen, über die das zweite Erkennungsmittel 12 mit einer Systemkontrolleinheit 15 verbunden ist. Eine solche Systemkontrolleinheit 15 ist in vielen Computersystem vorhanden. Ihre Aufgabe ist unter anderem, Informationen über die Konfiguration des Systems zu sammeln und auf Anfragen, z.B. über den sogenannten System-Management-Bus, zur Verfügung zu stellen. Auf einem solchen Weg kann das zweite Erkennungsmittel 12 somit den Typ der Steuervorrichtung 6 ermitteln und diese Information wie beim ersten Ausführungsbeispiel an den Vergleicher 13 weiterleiten.

Eine weitere Möglichkeit zur Ermittlung von Konfigurationsinformationen ist durch ein manuell einstellbares Konfigurationselement 16 gegeben. Das Konfigurationselement 16 kann z.B. durch einen DIL/DIP-Schalter oder durch eine Anordnung von Steckbrücken auf der Steckerplatine 1 realisiert sein. In diesem Fall muss der Typ der benutzten Steuervorrichtung 6 bei der Verbindung der Steuervorrichtung 6 mit der Steckerplatine 1 manuell eingegeben werden. Diese Lösung birgt zwar die Gefahr, dass die Konfigurationsinformationen nicht korrekt sind oder bei einem Tausch der Steuervorrichtung 6 nicht auf den aktuellen Stand gebracht werden, ist dafür aber kostengünstig zu realisieren.

Weiterhin ist in Figur 2 eine zusätzliche akustische Warnvorrichtung 17 vorgesehen. Die akustische Warnvorrichtung 17 wird bei Aktivierung einer der optischen Signaleinrichtung 9 ebenfalls aktiviert und unterstützt somit deren Hinweisfunktion.

Bezugszeichen
- 1: Steckerplatine
- 2: Einschubrahmen
- 3: Peripheriegerät
- 4: Steckverbinder
- 5: weiterer Steckverbinder
- 6: Steuervorrichtung
- 7: Kabel
- 8: Steckverbinder der Steuervorrichtung 6
- 9: optische Signaleinrichtung
- 10: Überwachungseinrichtung
- 11: erstes Erkennungsmittel
- 12: zweites Erkennungsmittel
- 13: Vergleicher
- 14: Schnittstelle
- 15: Systemkontrolleinheit
- 16: Konfigurationselement
- 17: akustische Warneinrichtung

## Patentansprüche

1. Steckerplatine (1) zum Einsatz in einem Einschubrahmen (2) für Peripheriegeräte (3) mit
- mindestens einem Steckplatz mit Steckverbinder (4) zum Anschluss von in den Einschubrahmen (2) eingeschobenen Peripheriegeräten (3), wobei der Steckverbinder (4) aufgrund seiner mechanischen Auslegung den Einschub von mindestens zwei Typen von Peripheriegeräten (3) zulässt, die sich durch die elektrischen Eigenschaften der Signale der Peripheriegeräte (3) unterscheiden,
- mindestens einem weiteren Steckverbinder (5) zur Verbindung der Steckerplatine (1) mit mindestens einer Steuervorrichtung (6), wobei der weitere Steckverbinder (5) aufgrund seiner mechanischen Auslegung den Anschluss von mindestens zwei verschiedenen Typen von Steuervorrichtungen (6) zulässt, die sich durch die elektrischen Eigenschaften der Signale unterscheiden, und wobei der weitere Steckverbinder (5) durch die Steckerplatine (1) mit einem oder mehreren der Steckverbinder (4) der Steckplätze zum Austausch von Signalen zwischen der Steuervorrichtung (6) und den Peripheriegeräten (3) verbunden ist und
- jeweils eine, einem Steckplatz zugeordnete optische Signaleinrichtung (9),
wobei eine Überwachungseinrichtung (10) vorgesehen ist, die dazu eingerichtet ist,
- für jedes angeschlossene Peripheriegerät (3) zu ermitteln, ob dieses Peripheriegerät (3) mit der mit ihm verbundenen Steuervorrichtung (6) elektrisch kompatibel ist, und
- falls ermittelt wird, das eines der Peripheriegeräte (3) mit der mit ihm verbundenen Steuervorrichtung (6) nicht kompatibel ist, die dem Steckplatz dieses Peripheriegerätes (3) zugeordnete optische Signaleinrichtung (9) zu aktivieren.

2. Steckerplatine (1) nach Anspruch 1, **dadurch gekennzeichnet, dass** die Überwachungseinrichtung (10)
- ein erstes Erkennungsmittel (11) aufweist, das dazu eingerichtet ist, den Typ eines Peripheriegeräts (3) zu erkennen,
- ein zweites Erkennungsmittel (12) aufweist, das dazu eingerichtet ist, den Typ einer Steuervorrichtung (6) zu erkennen,
- einen Vergleicher (13) aufweist, der den Typ jedes Peripheriegeräts (3) mit dem Typ der mit diesem Peripheriegerät (3) verbundenen Steuervorrichtung (6) vergleicht, wobei bei vorgegebenen Typkombinationen als Ergebnis des Vergleichs eine Inkompatibilität signalisiert wird und
- dazu eingerichtet ist, bei Signalisierung einer Inkompatibilität durch den Vergleicher (13) die entsprechende optische Signaleinrichtung (9) zu aktivieren.

3. Steckerplatine (1) nach Anspruch 2, **dadurch gekennzeichnet, dass** das erste Erkennungsmittel (11) dazu eingerichtet ist, den Typ eines eingeschobenen Peripheriegeräts (3) anhand der elektrischen Eigenschaften und/oder der Protokolleigenschaften der Signale des Peripheriegeräts (3) zu erkennen.

4. Steckerplatine (1) nach Anspruch 2, **dadurch gekennzeichnet, dass** das zweite Erkennungsmittel (12) dazu eingerichtet ist, den Typ einer Steuervorrichtung (6) anhand der elektrischen Eigenschaften und/oder der Protokolleigenschaften der Signale der Steuervorrichtungen (6) zu erkennen.

5. Steckerplatine (1) nach Anspruch 2, **dadurch gekennzeichnet, dass** mindest ein manuell einzustellendes Konfigurationselement (16) vorgesehen ist und das zweite Erkennungsmittel (12) dazu eingerichtet ist, den Typ einer Steuervorrichtung (6) anhand des mindestens einen Konfigurationselements (16) zu erkennen.

6. Steckerplatine (1) nach Anspruch 2, **dadurch gekennzeichnet, dass** eine Schnittstelle (14) vorgesehen ist, über die Konfigurationsinformationen an die Steckerplatine (1) übertragbar sind und das zweite Erkennungsmittel (12) dazu eingerichtet ist, den Typ einer Steuervorrichtung (6) anhand der Konfigurationsinformationen zu erkennen.

7. Steckerplatine (1) nach einem der Ansprüche 1 bis 6, **dadurch gekennzeichnet, dass** zwei mögliche Typen für die Peripheriegeräte (3) und die mindestens eine Steuervorrichtung (6) vorgesehen sind, wobei die Signale des einen Typs der SATA (Serial ATA) Spezifikation und die Signale des anderen Typs der SAS (Serial Attached SCSI) Spezifikation folgen.

8. Steckerplatine (1) nach Anspruch 5, **dadurch gekennzeichnet, dass** das erste Erkennungsmittel (11) den Typ eines Peripheriegeräts (3) an dem Signal an dem Anschluss des Steckverbinders (4) erkennt, der gemäß der SAS-Spezifikation durch ein Peripheriegerät (3) mit Masse verbunden ist, gemäß der SATA-Spezifikation jedoch nicht.

9. Steckerplatine (1) nach Anspruch 3, **dadurch gekennzeichnet, dass** das erste Erkennungsmittel (11) den Typ eines Peripheriegeräts (3) an den Signalen an solchen Anschlüssen des Steckverbinders (4) erkennt, die gemäß der SAS-Spezifikation und der SATA-Spezifikation zur Datenübertragung genutzt werden, und die in beiden Spezifikationen unterschiedliche Amplituden und/oder Protokolleigenschaften haben.

10. Steckerplatine (1) nach Anspruch 4, **dadurch gekennzeichnet, dass** das zweite Erkennungsmittel (12) den Typ einer Steuervorrichtung (6) an den Signalen an solchen Anschlüssen des Steckverbinders (4) erkennt, die zur Datenübertragung genutzt werden, indem eine von der Steuervorrichtung (6) übertragene Kennung ausgewertet wird.

11. Steckerplatine (1) nach einem der Ansprüche 1 bis 10, **dadurch gekennzeichnet, dass** eine akustische Warnvorrichtung (17) vorgesehen ist, die bei Aktivierung einer der optischen Signaleinrichtungen (9) ebenfalls aktiviert wird.

12. Datenverarbeitungsvorrichtung mit einem Einschubrahmen (2) zur Aufnahme mehrerer Peripheriegeräte (3), **dadurch gekennzeichnet, dass** in Verbindung mit dem Einschubrahmen (2) eine Steckerplatine (1) nach einem der Ansprüche 1 bis 11 vorgesehen ist.

## Claims

1. A backplane (1) for use in a push-in frame (2) for peripherals (3), said backplane having
- at least one slot having plug connectors (4) for connecting peripherals (3) which have been pushed into the push-in frame (2), on account of its mechanical design, the plug connector (4) allowing at least two types of peripherals (3) to be pushed in, which differ by virtue of the electrical properties of the signals from the peripherals (3),
- at least one further plug connector (5) for connecting the backplane (1) to at least one control apparatus (6), on account of its mechanical design, the further plug connector (5) allowing at least two different types of control apparatuses (6) to be connected, which differ by virtue of the electrical properties of the signals, and the further plug connector (5) being connected to one or more of the plug connectors (4) of the slots by means of the backplane (1) for the purpose of interchanging signals between the control apparatus (6) and the peripherals (3), and
- a respective optical signaling device (9) which is assigned to a slot,
provision being made of a monitoring device (10) which is set up
- to determine, for each connected peripheral (3), whether this peripheral (3) is electrically compatible with the control apparatus (6) connected to it and,
- if it is determined that one of the peripherals (3) is not compatible with the control apparatus (6) connected to it, to activate the optical signaling device (9) assigned to the slot for this peripheral (3).

2. Backplane (1) according to Claim 1, **characterized in that** the monitoring device (10)
- has a first detection means (11) which is set up to detect the type of peripheral (3),
- has a second detection means (12) which is set up to detect the type of control apparatus (6),
- has a comparator (13) which compares the type of each peripheral (3) with the type of control apparatus (6) connected to this peripheral (3), incompatibility being signaled as the result of the comparison in the case of predetermined type combinations, and
- is set up to activate the corresponding optical signaling device (9) when the comparator (13) signals incompatibility.

3. Backplane (1) according to Claim 2, **characterized in that** the first detection means (11) is set up to detect the type of peripheral (3), which has been pushed in, using the electrical properties and/or the protocol properties of the signals from the peripheral (3).

4. Backplane (1) according to Claim 2, **characterized in that** the second detection means (12) is set up to detect the type of control apparatus (6) using the electrical properties and/or the protocol properties of the signals from the control apparatuses (6).

5. Backplane (1) according to Claim 2, **characterized in that** at least one configuration element (16) which can be manually set is provided, and the second detection means (12) is set up to detect the type of control apparatus (6) using the at least one configuration element (16).

6. Backplane (1) according to Claim 2, **characterized in that** provision is made of an interface (14) which can be used to transmit configuration information to the backplane (1), and the second detection means (12) is set up to detect the type of control apparatus (6) using the configuration information.

7. Backplane (1) according to one of Claims 1 to 6, **characterized in that** two possible types are provided for the peripherals (3) and the at least one control apparatus (6), the signals of one type following the SATA (Serial ATA) specification and the signals of the other type following the SAS (Serial Attached SCSI) specification.

8. Backplane (1) according to Claim 5, **characterized in that** the first detection means (11) detects the type of peripheral (3) from the signal at that connection of the plug connector (4) which is connected to ground by means of a peripheral (3) in accordance with the SAS specification but not in accordance with the SATA specification.

9. Backplane (1) according to Claim 3, **characterized in that** the first detection means (11) detects the type of peripheral (3) from the signals at those connections of the plug connector (4) which are used to transmit data in accordance with the SAS specification and the SATA specification and have different amplitudes and/or protocol properties in the two specifications.

10. Backplane (1) according to Claim 4, **characterized in that** the second detection means (12) detects the type of control apparatus (6) from the signals at those connections of the plug connector (4) which are used to transmit data by evaluating an identifier which has been transmitted by the control apparatus (6).

11. Backplane (1) according to one of Claims 1 to 10, **characterized in that** provision is made of an acoustic warning device (17) which is likewise activated when one of the optical signaling devices (9) is activated.

12. Data processing apparatus having a push-in frame (2) for holding a plurality of peripherals (3), **characterized in that** a backplane (1) according to one of Claims 1 to 11 is provided in conjunction with the push-in frame (2).

## Revendications

1. Carte à fiche mâle (1) destinée à être utilisée dans un châssis enfichable (2) pour appareils périphériques (3), comprenant
- au moins un emplacement d'extension muni d'un connecteur (4) pour le raccordement des appareils périphériques (3) insérés dans le châssis enfichable (2), le connecteur (4), du fait de sa conception mécanique, permettant l'insertion d'au moins deux types d'appareils périphériques (3) qui se différencient par les propriétés électriques des signaux des appareils périphériques (3)
- au moins un connecteur (5) supplémentaire pour relier la carte à fiche mâle (1) avec au moins un dispositif de commande (6), le connecteur supplémentaire (5), du fait de sa conception mécanique, permettant le raccordement d'au moins deux types différents de dispositifs de commande (6) qui se différencient par les propriétés électriques des signaux et le connecteur supplémentaire (5) étant relié par le biais de la carte à fiche mâle (1) avec un ou plusieurs des connecteurs (4) des emplacements d'extension pour échanger des signaux entre le dispositif de commande (6) et les appareils périphériques (3) et
- à chaque fois un dispositif de signal optique (9) associé à un emplacement d'extension, un dispositif de surveillance (10) étant prévu, lequel est configuré
- pour déterminer pour chaque appareil périphérique (3) raccordé si cet appareil périphérique (3) est compatible avec le dispositif de commande (6) qui est relié avec lui et
- s'il est déterminé que l'appareil périphérique (3) n'est pas compatible avec le dispositif de commande (6) qui est relié avec lui, pour activer le dispositif de signal optique (9) associé à l'emplacement d'extension de cet appareil périphérique (3).

2. Carte à fiche mâle (1) selon la revendication 1, **caractérisée en ce que** le dispositif de surveillance (10)
- présente un premier moyen de détection (11) qui est configuré pour reconnaître le type d'un appareil périphérique (3),
- présente un deuxième moyen de détection (12) qui est conçu pour reconnaître le type d'un dispositif de commande (6),
- présente un comparateur (13) qui compare le type de chaque appareil périphérique (3) avec le type du dispositif de commande (6) relié avec cet appareil périphérique (3), le résultat de la comparaison en présence de combinaisons de types prédéfinies étant la signalisation d'une incompatibilité et
- est configuré pour activer le dispositif de signal optique (9) en cas de signalisation d'une incompatibilité par le comparateur (13).

3. Carte à fiche mâle (1) selon la revendication 2, **caractérisée en ce que** le premier moyen de détection (11) est configuré pour reconnaître le type d'un appareil périphérique (3) inséré au moyen des propriétés électriques et/ou des propriétés de protocole du signal de l'appareil périphérique (3).

4. Carte à fiche mâle (1) selon la revendication 2, **caractérisée en ce que** le deuxième moyen de détection (12) est configuré pour reconnaître le type d'un dispositif de commande (6) inséré au moyen des propriétés électriques et/ou des propriétés de protocole du signal des dispositifs de commande (6).

5. Carte à fiche mâle (1) selon la revendication 2, **caractérisée en ce qu'**il est prévu au moins un élément de configuration (16) à réglage manuel et le deuxième moyen de détection (12) est configuré pour reconnaître le type d'un dispositif de commande (6) au moyen de l'au moins un élément de configuration (16).

6. Carte à fiche mâle (1) selon la revendication 2, **caractérisée en ce qu'**il est prévu une interface (14) par le biais de laquelle des informations de configuration peuvent être transmises à la carte à fiche mâle (1) et le deuxième moyen de détection (12) est configuré pour reconnaître le type d'un dispositif de commande (6) au moyen des informations de configuration.

7. Carte à fiche mâle (1) selon l'une des revendications 1 à 6, **caractérisée en ce que** sont prévus deux types possibles pour les appareils périphériques (3) et l'au moins un dispositif de commande (6), les signaux d'un type obéissant à la spécification SATA (Serial ATA) et les signaux de l'autre type à la spécification SAS (Serial Attached SCSI).

8. Carte à fiche mâle (1) selon la revendication 5, **caractérisée en ce que** le premier moyen de détection (11) reconnaît le type d'un appareil périphérique (3) au signal sur la borne du connecteur (4) qui, d'après la spécification SAS, est reliée à la masse par un appareil périphérique (3), mais ne l'est pas d'après la spécification SATA.

9. Carte à fiche mâle (1) selon la revendication 3, **caractérisée en ce que** le premier moyen de détection (11) reconnaît le type d'un appareil périphérique (3) aux signaux sur les bornes du connecteur (4) qui, d'après la spécification SAS et la spécification SATA, sont utilisées pour la transmission de données et qui présentent des amplitudes et/ou des caractéristiques de protocole différentes dans les deux spécifications.

10. Carte à fiche mâle (1) selon la revendication 4, **caractérisée en ce que** le deuxième moyen de détection (12) reconnaît le type d'un dispositif de commande (6) aux signaux sur les bornes du connecteur (4) qui sont utilisées pour la transmission de données en interprétant un identifiant transmis par le dispositif de commande (6).

11. Carte à fiche mâle (1) selon l'une des revendications 1 à 10, **caractérisée en ce qu'**il est prévu un dispositif d'alerte sonore (17) qui est également activé lors de l'activation de l'un des dispositifs de signal optique (9).

12. Dispositif de transmission de données comprenant un châssis enfichable (2) destiné à recevoir plusieurs appareils périphériques (3), **caractérisé en ce qu'**il est prévu une carte à fiche mâle (1) selon l'une des revendications 1 à 11 en combinaison avec le châssis enfichable (2).
